# EUROPÄISCHE PATENTSCHRIFT

(11) **EP 0 777 939 B1**
(45) Veröffentlichungstag und Bekanntmachung des Hinweises auf die Patenterteilung: **20.05.1998**
(21) Anmeldenummer: 95928991.9
(22) Anmeldetag: 28.08.1995
(51) Int. Cl.: H04B 7/08, H04B 1/48

(54) **ANTENNENSCHALTER FÜR DRAHTLOSE ANTENNA DIVERSITY-TELEKOMMUNIKATIONSGERÄTE MIT ZWEI ANTENNEN**
AERIAL SWITCH FOR WIRELESS AERIAL DIVERSITY TELECOMMUNICATIONS DEVICES WITH TWO AERIALS
COMMUTATEUR D'ANTENNE POUR UNITES DE TELECOMMUNICATION SANS FIL A DEUX ANTENNES EN DIVERSITE DE RECEPTION

(30) Priorität: 31.08.1994 DE 4430987
(43) Veröffentlichungstag der Anmeldung: 11.06.1997
(73) Patentinhaber: SIEMENS AKTIENGESELLSCHAFT, 80333 München (DE)
(72) Erfinder: SAUER, Jürgen, D-46117 Oberhausen (DE); DETERING, Volker, D-46446 Emmerich (DE); LEPPING, Jürgen, D-45359 Essen (DE)
(86) Internationale Anmeldenummer: DE9501143
(87) Internationale Veröffentlichungsnummer: WO9607248

(56) Entgegenhaltungen:
- EP-A- 0 124 319
- EP-A- 0 218 843

## Beschreibung

Die Erfindung betrifft einen Antennenschalter für drahtlose Antenna Diversity-Telekommunikationsgeräte mit zwei Antennen gemäß dem Oberbegriff des Patentanspruches 1.

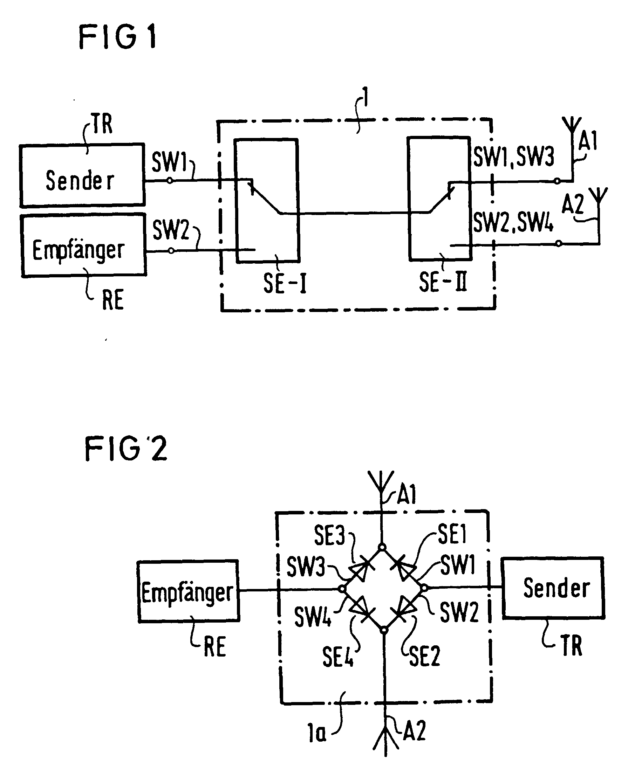

Drahtlose Antenna Diversity-Telekommunikationsgeräte - z.B. drahtlose **TDMA**-Telekommunikationsgeräte (**T**ime **D**ivision **M**ultiple **A**ccess) nach dem **DECT**-Standard (**D**igital **E**uropean **C**ordless **T**elecommunication; vgl. Nachrichtentechnik Elektronik, Berlin, Jg. 42, No. 1, 1-2/1992, Seiten 23 bis 29, U.Pilger: "Struktur des DECT-Standards") oder nach dem **GSM**-Standard (**G**roupe **S**péciale **M**obile oder **G**lobal **S**ystems for **M**obile Communication; vgl. Informatik Spektrum, Springer Verlag Berlin, Jg. 14, 1991, No. 3, Seiten 137 bis 152, A. Mann: "Der GSM-Standard - Grundlage für digitale europäische Mobilfunknetze") - mit zwei Antennen sind aus der WO 94/10812 (Figuren 1 und 2 mit der dazugehörigen Beschreibung) bekannt. Die bekannte Antenna Diversity- Funksendeeinrichtung/Funkempfangseinrichtung weist für das Umschalten zwischen den beiden Antennen (Realisierung des "Antenna Diversity") und das Umschalten zwischen Sende- und Empfangsbetrieb der Funksendeeinrichtung/Funkempfangseinrichtung einen Antennenschalter mit zwei hintereinandergeschalteten Schaltelementen (Diversity Switch DS und T/R-Switch T/R-S nach Figur 2 in der WO 94/10812) auf.

Figur 1 zeigt das Prinzipschaltbild eines solchen Kaskaden-Antennenschalters 1, der zwei hintereinandergeschaltete Schaltelemente, ein erstes Schaltelement SE-I und ein zweites Schaltelement SE-II, aufweist. Durch diese Schaltelemente SE-I, SE-II wird jeweils ein erster Signalweg SW1 von einem Sender TR zu einer ersten Sende-/Empfangsantenne A1, ein zweiter Signalweg SW2 vom Sender TR zu einer zweiten Sende/Empfangsantenne A2, ein dritter Signalweg SW3 von einem Empfänger RE zur ersten Sende-/Empfangsantenne A1 und ein vierter Signalweg SW4 vom Empfänger RE zur zweiten Sende/Empfangsantenne A2 selektiv durchgeschaltet. Bei dieser Kaskadenkonfiguration treten an jedem Schaltelement SE-I, SE-II für die Realisierung der vorstehend beschriebenen Schaltfunktionen Schaltverluste auf, die letztlich die abgestrahlte Sendeleistung und die Empfangsempfindlichkeit der Funksendeeinrichtung/Funkempfangseinrichtung unnötigerweise verringern.

Die der Erfindung zugrundeliegende Aufgabe besteht darin, bei Antennenschaltern für drahtlose Antenna Diversity-Telekommunikationsgeräte mit zwei Antennen auftretende Schaltverluste zu minimieren.

Diese Aufgabe wird ausgehend von dem in dem Oberbegriff des Patentanspruches 1 definierten Antennenschalter durch die in dem kennzeichnenden Teil des Patentanspruches 1 angegebenen Merkmale gelöst.

Dadurch, daß bei Antennenschaltern für drahtlose Antenna Diversity-Telekommunikationsgeräte mit zwei Sende/Empfangsantennen, z.B. Basisstation eines DECT-Schnurlostelefons, die dem Antennenschalter zugewiesenen, vorstehend beschriebenen Schaltfunktionen jeweils nur ein einziges elektronisches, beispielsweise als PIN- oder Schaltdiode ausgebildetes Schaltelement angeordnet ist (Aufbau einer Ringschaltung), können auftretende Schaltverluste gegenüber bekannten Antennenschaltern um die Hälfte reduziert werden. Darüber hinaus kann der vorstehend beschriebene Antennenschalter in ein einziges Gehäuse integriert werden, wodurch insbesondere die Bestück- bzw. Aufbaukosten des Antennenschalters reduziert werden.

Vorteilhafte Weiterbildungen der Erfindung sind in den Unteransprüchen angegeben.

Ein Ausführungsbeispiel der Erfindung wird anhand der Figur 2 erläutert.

Figur 2 zeigt ausgehend von dem Antennenschalter 1 nach Figur 1 einen modifizierten Antennenschalter 1a, bei dem für jeden Signalweg SW1...SW4 nach Figur 1 ein einziges elektronisches Schaltelement SE1...SE4, das z.B. als PIN-Diode oder als Schaltdiode ausgebildet sein kann, vorgesehen ist. Die Schaltelemente SE1...SE4 bilden dabei mit den Signalwegen SW1...SW4 eine Ringschaltung.

## Patentansprüche

1. Antennenschalter für drahtlose Antenna Diversity-Telekommunikationsgeräte mit zwei Sende-/Empfangsantennen, in dem jeweils selektiv durchschaltbar ein erster Signalweg (SW1) von einem Sender (TR) zu einer ersten Sende-/Empfangsantenne (A1), ein zweiter Signalweg (SW2) vom Sender (TR) zu einer zweiten Sende-/Empfangsantenne (A2), ein dritter Signalweg (SW3) von einem Empfänger (RE) zur ersten Sende/Empfangsantenne (A1) und ein vierter Signalweg (SW4) vom Empfänger (RE) zur zweiten Sende-/Empfangsantenne (A2) angeordnet ist, **dadurch gekennzeichnet,** daß
in jedem Signalweg (SW1...SW4) ein elektronisches Schaltelement (SE1...SE4) angeordnet ist und daß die Schaltelemente (SE1...SE4) zu einer Ringschaltung zusammengeschaltet sind.

2. Antennenschalter nach Anspruch 1, **dadurch gekennzeichnet,** daß
die Schaltelemente (SE1...SE4) als PIN-Dioden ausgebildet sind.

3. Antennenschalter nach Anspruch 1, **dadurch gekennzeichnet,** daß
die Schaltelemente (SE1...SE4) als Schaltdioden ausgebildet sind.

## Claims

1. Antenna switch for wireless antenna diversity telecommunications devices with two transmission/ reception antennas, in which antenna switch there are arranged in each case so as to be capable of being switched through selectively, a first signal path (SW1) from a transmitter (TR) to a first transmission/reception antenna (A1), a second signal path (SW2) from the transmitter (TR) to a second transmission/reception antenna (A2), a third signal path (SW3) from a receiver (RE) to the first transmission/reception antenna (A1) and a fourth signal path (SW4) from the receiver (RE) to the second transmission/reception antenna (A2), characterized in that an electronic switching element (SE1..SE4) is arranged in each signal path (SW1...SW4), and in that the switching elements (SE1...SE4) are connected together to form a ring circuit.

2. Antenna switch according to Claim 1, characterized in that the switching elements (SE1...SE4) are constructed as PIN diodes.

3. Antenna switch according to Claim 1, characterized in that the switching elements (SE1...SE4) are constructed as switching diodes.

## Revendications

1. Commutateur d'antenne pour des appareils de télécommunication sans fil en diversité d'antenne comportant deux antennes émettrices réceptrices, dans lequel il est agencé, de manière à pouvoir effectuer à chaque fois un branchement sélectif, une première voie de signal (SW1) d'un émetteur (TR) à une première antenne émettrice réceptrice (A1), une deuxième voie de signal (SW2) de l'émetteur (TR) à une deuxième antenne émettrice réceptrice (A2), une troisième voie de signal (SW3) d'un récepteur (RE) à la première antenne émettrice réceptrice (A1) et une quatrième voie de signal (SW4) du récepteur (RE) à la deuxième antenne émettrice réceptrice (A2), caractérisé par le fait qu'un élément de commutation électronique (SE1 à SE4) est agencé dans chaque voie de signal (SW1 à SW4) et que les éléments de commutation (SE1 à SE4) sont branchés ensemble en un montage polygonal.

2. Commutateur d'antenne selon la revendication 1, caractérisé par le fait que les éléments de commutation (SE1 à SE4) sont conçus sous forme de diodes PIN.

3. Commutateur d'antenne selon la revendication 1, caractérisé par le fait que les éléments de commutation (SE1 à SE4) sont conçus sous forme de diodes de commutation.
